# DEMANDE DE BREVET EUROPEEN

(11) **EP 4 336 544 A2**
(43) Date de publication de la demande: **13.03.2024**
(21) Numéro de dépôt: 23219424.1
(22) Date de dépôt: 15.09.2016
(51) Int. Cl.: H01L 21/02

(54) **STRUCTURE SEMI-CONDUCTRICE À TENUE EN TENSION AMÉLIORÉE**

(30) Priorité: 17.09.2015 FR 1558766
(62) Demande divisionnaire de: 16189001.7
(71) Demandeur: Commissariat à l'Énergie Atomique et aux Énergies Alternatives, 75015 Paris (FR)
(72) Inventeur: BAVARD, Alexis, 38360 Sassenage (FR); CHARLES, Matthew, 38000 Grenoble (FR)
(74) Mandataire: Brevalex

(57) **Abrégé**

Structure semi-conductrice comportant au moins :
- un substrat (102),
- une couche tampon (104),
- un super-réseau formé sur la couche tampon (104), ledit super-réseau comportant un motif comprenant deux couches en matériaux différents (106, 108), chaque couche (106, 108) comportant un matériau de type AlₓGa_{y}In_{w}B_{z}N avec x + y + w +z = 1, l'épaisseur de chaque couche (106, 108) étant inférieure à son épaisseur critique, le nombre de motifs étant au moins égal à 50,
- une couche intercalaire (110) dont le matériau présente un premier paramètre de maille,
- une couche de matériau de GaN (112), dont le paramètre de maille est supérieur au premier paramètre de maille de sorte que la couche de matériau de GaN (112) soit mise en compression par la couche intercalaire (110).

## Description

### DOMAINE TECHNIQUE ET ÉTAT DE LA TECHNIQUE ANTÉRIEURE

La présente invention se rapporte à une structure semi-conductrice présentant une tenue en tension améliorée.

Parmi les différents matériaux semi-conducteurs existants, le GaN ou nitrure de Gallium permet de réaliser des dispositifs électroniques de bonne qualité.

Afin de réaliser des dispositifs électroniques comportant du GaN à un coût raisonnable, on cherche à réaliser des structures comportant une ou des couches de GaN sur un substrat silicium.

Or le GaN et le silicium ne présentent pas les mêmes paramètres de maille ni des coefficients de dilatation thermiques proches ou égaux. Ainsi, si aucune précaution n'est prise, le GaN obtenu n'est pas de bonne qualité et, lors du refroidissement après le dépôt du GaN, des fissures apparaissent dans la ou les couches de GaN. Afin de pallier cet inconvénient, une ou des couches tampons sont interposées entre le substrat et la ou les couches de GaN, celles-ci imposant des contraintes de compression dans le GaN, ce qui lors du refroidissement évite l'apparition de fissures dans la couche de GaN. En outre, la présence de la ou des couches tampons évite que le GaN soit en contact du silicium, ce qui sinon provoquerait l'apparition de défauts cristallins dans le GaN.

Le matériau de la couche tampon est par exemple de l'AIN.

On cherche par ailleurs à réaliser une couche de GaN présentant une épaisseur suffisante nécessaire pour la plupart des applications.

Le document WO2013001014 décrit une structure semi-conductrice comportant une couche de GaN épaisse. Cette couche épaisse de GaN est obtenue en réalisant, sur une couche tampon AIN formée sur un substrat en silicium monocristallin, une couche de GaN 3D qui a comme but l'amélioration de la qualité des couches GaN. Une couche épaisse de GaN de bonne qualité peut alors être réalisée sur cette couche de GaN 3D après l'insertion d'une couche intercalaire.

Une des applications des structures semi-conductrices comportant une couche de GaN est l'électronique de puissance, notamment la réalisation de transistors de forte puissance. Dans cette application, on cherche à obtenir un courant de fuite vertical, i.e. dans la hauteur de l'empilement des couches, très faible.

Or la couche de GaN 3D n'offre pas une isolation électrique verticale suffisante.

### EXPOSÉ DE L'INVENTION

C'est par conséquent un but de la présente invention d'offrir une structure semi-conductrice comportant une couche de GaN, plus généralement de matériau de type III-N, offrant une bonne tenue en tension de sorte à être adaptée par exemple à la réalisation de transistor de forte puissance tout en présentant une couche de GaN suffisamment épaisse, plus généralement de matériau de type III-N, et de qualité suffisante.

Le but mentionné ci-dessus est atteint par une structure semi-conductrice comportant un substrat, une couche tampon, au moins un super-réseau formé sur la couche tampon, une couche intercalaire, une couche de GaN mis en compression par la couche intercalaire, le super-réseau comportant un motif comprenant n couches en des matériaux différents, n étant un entier supérieur ou égal à 2, le motif étant répété un grand nombre de fois. Chaque couche du motif comporte un matériau du type AlₓGa_{y}In_{w}B_{z}N avec x + y + w +z = 1 et a une épaisseur inférieure à l'épaisseur critique du matériau dont elle est formée. De préférence, le motif est répété au moins 50 fois.

De manière préférée, la structure comporte au moins 100 motifs.

De manière très avantageuse, l'épaisseur de chaque couche est comprise entre 0,5 nm et 5 nm et de préférence inférieure ou égale à 1 nm. De manière préférée, l'épaisseur du motif est inférieure ou égale à 5 nm.

Dans la présente demande, un super-réseau est une structure multicouche périodique formée par la répétition d'un motif élémentaire comprenant au moins deux couches successives chimiquement différentes.

Selon l'invention, le super-réseau n'a pas pour principal objectif d'assurer la mise en compression du III-N qui est formé sur le super-réseau mais d'assurer l'isolation électrique verticale, notamment du fait d'un grand nombre d'interfaces entre les couches du super-réseau. L'application de la contrainte compressive est assurée par la couche dite intercalaire. L'invention permet donc de décorréler les fonctions d"isolation électrique et de contrainte compressive sur la couche active épaisse de III-N, ce qui permet d'optimiser l'isolation électrique et la mise en compression de manière sensiblement indépendante.

Cette décorrélation offre en outre une certaine liberté sur la composition des couches du réseau, ce qui permet d'avoir des couches riches en aluminium présentant des largeurs de bande énergétique plus élevées que celle du GaN.

En outre, le super-réseau peut réduire la densité de dislocations, ce qui facilite davantage la formation de GaN épais sur l'intercalaire. En outre, dues aux fines épaisseurs mises en jeu, il n'y pas d'apparition de gaz d'électrons bidimensionnel entre le super-réseau et la couche intercalaire AIN, contrairement à un empilement de GaN et d'AIN.

De manière avantageuse, on prévoit au moins une couche supplémentaire entre la couche intercalaire et la couche de III-N, dont le matériau présente un paramètre de maille compris entre celui du matériau de la couche intercalaire et la couche de III-N, ainsi on augmente progressivement le paramètre de maille de la couche intercalaire à la couche de III-N.

La présente invention a alors pour objet une structure semi-conductrice comportant au moins :
- un substrat,
- une couche tampon,
- un super-réseau formé sur la couche tampon, ledit super-réseau comportant un motif comprenant n couches en des matériaux différents, n étant un entier au moins égal à 2, chaque couche comportant un matériau de type AlₓGa_{y}In_{w}B_{z}N avec x + y + w +z = 1, l'épaisseur de chaque couche étant inférieure à son épaisseur critique, le nombre de motifs étant au moins égal à 50,

- une couche intercalaire dont le matériau présente un premier paramètre de maille,
- une couche de matériau de type III-N, dont le paramètre de maille est supérieur au premier paramètre de maille de sorte que la couche de matériau de type III-N soit mise en compression par la couche intercalaire.

De préférence, l'épaisseur de chaque couche du super-réseau est inférieure ou égale à 5 nm, de manière encore préférée égale à 1 nm.

L'épaisseur de chaque motif est avantageusement inférieure ou égale à 5 nm.

La structure peut comporter au moins une couche en matériau de type AlₓGa_{y}In_{w}B_{z}N avec x + y + w +z = 1 entre la couche intercalaire et la couche de matériau de type III-N présentant un deuxième paramètre de maille supérieur au premier paramètre de maille et inférieur au paramètre de maille du matériau de type III-N

La couche intercalaire a de préférence une épaisseur au moins égale à 10nm et peut être une couche d'AIN. En variante, la couche intercalaire est un super-réseau.

Le substrat peut avantageusement comporter du silicium monocristallin.

Selon un autre exemple, la structure comporte au moins une couche supplémentaire de matériau de type III-N interposée entre le super-réseau et la couche intercalaire et/ou au moins une couche supplémentaire de matériau de type III-N interposée entre la couche intercalaire et la couche de matériau III-N. Cette couche supplémentaire a de préférence une épaisseur d'au moins 50 nm.

La structure peut comporter plusieurs super-réseaux superposés.

De manière préférée, le matériau de type III-N est du nitrure de Gallium.

La présente invention a également pour objet un transistor comportant au moins une structure selon l'invention, celui-ci étant par exemple un transistor HEMT.

La présente invention a également pour objet un procédé de réalisation d'une structure semi-conductrice comportant les étapes à partir d'un substrat :
a) formation d'une couche tampon,
b) formation d'un super-réseau comportant les sous-étapes :
   b1) réalisation d'un motif comprenant n couches, n étant un entier au moins égal à 2, chaque couche comportant un matériau de type AlₓGa_{y}In_{w}B_{z}N avec x + y + w +z = 1, l'épaisseur de chaque couche étant inférieure à son épaisseur critique,
   b2) répétition de l'étape b1) au moins 50 fois,
c) formation d'une couche intercalaire présentant un premier paramètre de maille,
d) formation d'une couche en matériau de type III-n dont le paramètre de maille est supérieur au première paramètre de maille.

Lors de l'étape b), du carbone est avantageusement incorporé dans les couches du super-réseau.

De préférence, les couches de la structure sont formées par croissance, avantageusement par épitaxie en phase vapeur aux organométalliques.

### BRÈVE DESCRIPTION DES DESSINS

La présente invention sera mieux comprise sur la base de la description qui va suivre et des dessins en annexe sur lesquels :
- la figure 1 est une représentation schématique d'un exemple d'une structure semi-conductrice selon l'invention,
- la figure 2 est une représentation schématique d'un autre exemple d'une structure semi-conductrice selon l'invention,
- la figure 3 est une représentation schématique d'un autre exemple d'une structure semi-conductrice selon l'invention,
- la figure 4 est une représentation schématique d'un autre exemple d'une structure semi-conductrice selon l'invention,
- la figure 5 est une représentation graphique de la variation du courant de fuite verticale en fonction de la tension appliquée dans une structure semi-conductrice selon un mode de réalisation particulier de l'invention et dans une structure comportant du GaN 3D,
- la figure 6 représente schématiquement un transistor de puissance formé sur une structure semi-conductrice selon un mode de réalisation particulier de l'invention,
- la figure 7 représente schématiquement une diode électroluminescente formée sur une structure semi-conductrice selon un mode de réalisation particulier de l'invention.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

La description qui va suivre va porter sur des structures semi-conductrices comportant une couche épaisse de GaN à laquelle des contraintes de compression sont appliquées. Mais la présente invention porte plus généralement sur toute structure semi-conductrice comportant une couche en matériau de type III-N, c'est-à-dire en nitrure d'un matériau de la colonne III du tableau périodique tel que le bore, l'indium, etc. Il en résulte que, dans la description qui va suivre, lorsque l'on souhaite réaliser une structure comportant une couche de type III-N au lieu de GaN, il suffit de remplacer dans les différentes couches de la structure le Gallium par le matériau de type III.

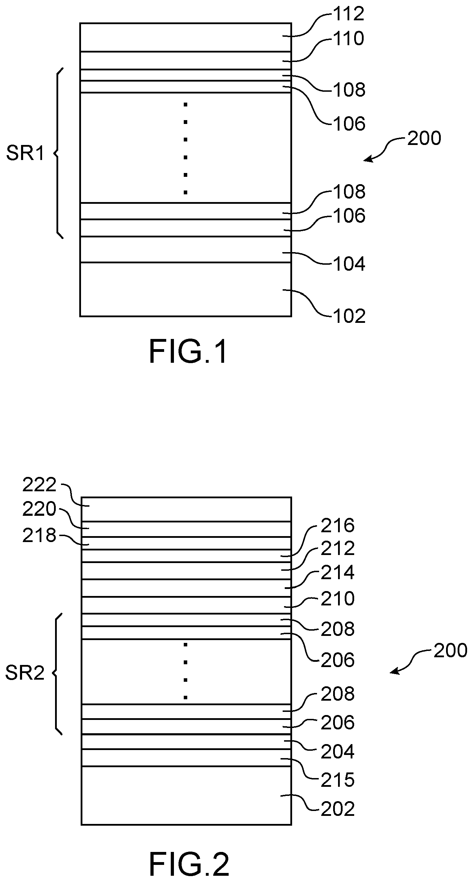

Sur la figure 1, un exemple d'une structure semi-conductrice 100 selon l'invention comportant un empilement de plusieurs couches.

L'empilement comporte un substrat 102 formant la base de l'empilement. Le substrat 102 est par exemple en silicium monocristallin par exemple de type (111). L'épaisseur du substrat est par exemple comprise entre 500 µm et 2 mm. En variante, le substrat 102 pourrait être réalisé par exemple en saphir, qui permet d'éviter les couches de conduction à l'interface entre le GaN et le saphir.

L'empilement comporte également une couche tampon 104 formée sur le substrat 102. Cette couche tampon 104 sert de couche de nucléation pour la croissance des autres couches. La couche tampon comporte par exemple de l'AIN et a une épaisseur comprise par exemple entre 50 nm et 500 nm, et de préférence comprise entre 200 nm et 300 nm. Cette couche tampon a également pour rôle d'isoler le substrat de la ou des couches de GaN qui seront formés par la suite. En variante la couche tampon peut comporter du SiC.

L'empilement comporte également un super-réseau SR1 formé sur la couche tampon 104.

Comme cela a été indiqué ci-dessus, un super-réseau est une structure multicouche périodique formée par la répétition, un grand nombre de fois, d'un motif élémentaire comprenant au moins deux couches successives chimiquement différentes. Le super-réseau comporte de préférence au moins 50 motifs élémentaires.

Dans l'exemple de la figure 1, le super-réseau SR1 selon l'invention comporte un motif comprenant deux couches, une couche 106 Alₓ₁Ga_{y1}In_{w1}B_{z1}N avec x₁ + y₁ + w₁ +z₁ = 1et une couche 108 de Alₓ₂Ga_{y2}In_{w2}B_{z2}N avec x₂ + y₂ + w₂ +z₂ =1. Les matériaux de deux couches successives dans le super-réseau sont différents. Par exemple, les valeurs de x₁ et x₂ sont différentes, y₁ et y₂ sont différentes, w₁ et w₂ sont différentes et z₁ et z₂ sont différentes.

En outre les couches 106 et 108 ont des épaisseurs inférieures aux épaisseurs critiques. Ainsi les couches 106 et 108 présentent de très faibles densités de dislocations. Les épaisseurs critiques sont égales au plus à 5 nm.

Dans la présente demande, on entend par « épaisseur critique », l'épaisseur à partir de laquelle le matériau d'une couche commence à se relaxer et donc à reprendre son paramètre de maille sans contrainte

Par exemple, les épaisseurs des couches 106 et 108 sont comprises entre 0,5 nm et 5 nm, et de préférence inférieure ou égale à 1 nm. De manière préférée, l'épaisseur du motif, i.e. la somme des épaisseurs des couches 106 et 108 est inférieure ou égale à 5 nm. Les deux couches peuvent avoir des épaisseurs égales ou différentes. L'empilement comporte également une couche intercalaire 110 formée sur le super-réseau SR1 apte à appliquer des contraintes de compression à une couche de GaN 112 formée sur la couche intercalaire 110.

La couche intercalaire 110 comporte un matériau présentant un paramètre de maille inférieur à celui du GaN afin d'appliquer au GaN des contraintes de compression suffisantes permettant de réaliser une couche de GaN épaisse ne comportant pas de fissures. La couche intercalaire 110 a par exemple une épaisseur comprise entre 5 nm et 50 nm et de préférence égale à 17 nm. Par exemple la couche intercalaire 110 est en AIN.

La couche de GaN 112 a par exemple une épaisseur de 3µm.

A titre d'exemple, on peut réaliser un super-réseau comportant 340 répétitions d'un motif comprenant une couche 106 de GaN et une couche 108 de Al_{0,5}Ga_{0,5}N, chaque couche ayant une épaisseur de 1 nm.

Du fait du très grand nombre d'interfaces du super-réseau SR1 la résistance électrique du super-réseau est très élevée. Celui-ci assure donc une isolation électrique dans l'empilement entre la couche de GaN 112 et le substrat 102.

Comme indiqué ci-dessus, le super-réseau n'a pas pour fonction de contraindre en compression la couche de GaN mais d'assurer l'isolation électrique entre la couche de GaN, plus précisément le composant électronique formé sur la couche de GaN et le substrat.

Cette structure présente une très bonne tenue en tension, par exemple de plusieurs centaines de volts. Ainsi les fuites de courant dans l'empilement sont sensiblement réduites. La structure peut alors être utilisée dans l'électronique de haute puissance, par exemple pour réaliser des transistors HEMT pour High-electron-mobility transistor en terminologie anglo-saxonne ou des diodes Schottky.

En outre, on obtient une couche de GaN présentant une qualité cristallographique élevée, i.e. présentant peu de défauts.

De plus, grâce à l'invention, l'isolation électrique et l'application de contrainte de compression à la couche de GaN sont décorrelées, ce qui offre une plus grande liberté dans le choix de la composition en aluminium des couches 106 et 108. On peut alors avoir la ou les couches du motif élémentaires riches en aluminium, ce qui est favorable à l'obtention d'une isolation électrique élevée, puisque les alliages AIGaN présentent une largeur de bande énergétique plus élevée que le GaN

Par ailleurs, l'invention permet avantageusement d'incorporer du carbone en quantité importante dans l'empilement, ce qui augmente davantage la tenue en tension. Par exemple, le carbone peut être incorporé directement dans les couches du super-réseau lors de la formation de celles-ci de manière connue par l'homme du métier, par exemple lors d'une croissance des couches 106 et 108 par épitaxie en phase vapeur aux organométalliques ou MOCVD (Metalorganic Chemical Vapor Deposition en terminologie anglo-saxonne). L'incorporation du carbone en quantité importante dans le super-réseau n'a pas pour effet de détériorer la qualité cristalline contrairement aux structures de l'état de la technique. La concentration en carbone est par exemple égale à environ supérieure à 5. 10¹⁸.

En outre il peut être prévu de réaliser plusieurs super-réseaux selon l'invention, les uns aux dessus des autres, les compositions des couches des motifs variant d'un réseau à l'autre. Il peut être envisagé d'avoir des compositions des super-réseaux qui varient selon un sens donné entre le super-réseau situé au plus près du substrat et celui situé au plus près de la couche de GaN.

La combinaison de plusieurs super-réseaux selon l'invention permet encore d'augmenter la tenue en tension de la structure.

En variante, on peut remplacer la couche intercalaire d'AIN par un super-réseau apte à appliquer une contrainte de compression à la couche de GaN qui sera réalisée sur le super-réseau. Par exemple, les compositions des couches sont choisies de sorte que la composition moyenne du réseau soit élevée en AlGaN, par exemple de l'ordre de 80%.

D'autres exemples de structures semi-conductrices selon l'invention vont maintenant être décrits.

Sur la figure 2, on peut voir un autre exemple de structure semi-conductrice 200. La structure 200 comporte un substrat 202, par exemple en Si type (111), une couche tampon 204 par exemple en AIN, un super-réseau SR2 similaire au super-réseau SR1 de la structure 100, une couche intercalaire 210 similaire à la couche intercalaire 110, une couche 214 dont le matériau présente un paramètre de maille inférieur à celui du GaN mais supérieur à celui du matériau de la couche intercalaire 210. En insérant la couche 214 entre la couche intercalaire et la couche de GaN, on réduit progressivement la différence de paramètre de maille entre la couche intercalaire 210 et le GaN. L'ajout de la couche 214 a pour effet de mieux conserver la compression dans les couches, permettant la croissance d'une couche GaN plus épaisses sans fissuration pendant le refroidissement. Par exemple, la couche 214 est une couche d'AlGaN dont l'épaisseur est par exemple comprise entre 50 nm et 1000 nm, de préférence égale à 200nm. En variante, la couche 214 pourrait être un super-réseau.

En variante, on peut prévoir d'interposer plus d'une couche de AIGaN entre la couche intercalaire et la couche de GaN 312, ces couches étant alors disposées de sorte que leur paramètre de maille soit croissant de la couche en contact avec la couche intercalaire 210 vers la couche sur laquelle est formée la couche de GaN 212

En outre, dans l'exemple représenté une couche d'AlGaN 215 est formée entre la couche tampon 204 et le super-réseau SR2. Le super-réseau SR2 joue le même rôle qu'un AIGaN, c'est-à-dire qu'il aide à transmettre la compression de l'AIN au GaN. En outre, le super-réseau SR2 est plus résistif qu'un AIGaN, comme c'est le cas pour le super-réseau SR1. La couche 215 a par exemple une épaisseur égale à 0,5 µm.

Dans l'exemple représenté, la structure comporte également une couche de GaN 216 formée sur la couche de GaN 212 formant un canal, une couche 218 d'AIN, une couche d'AlGaN 220 et une couche de GaN 222.

En considérant un super-réseau comportant 340 répétitions d'un motif comprenant une couche 106 de GaN et une couche 108 de Al_{0,5}Ga_{0,5}N, chaque couche ayant une épaisseur de 1 nm, la structure 200 a par exemple une épaisseur de 4,8 µm.

En variante, la couche 214 en AlGaN peut être remplacée par un super-réseau qui a la même fonction que la couche d'AlGaN 214.

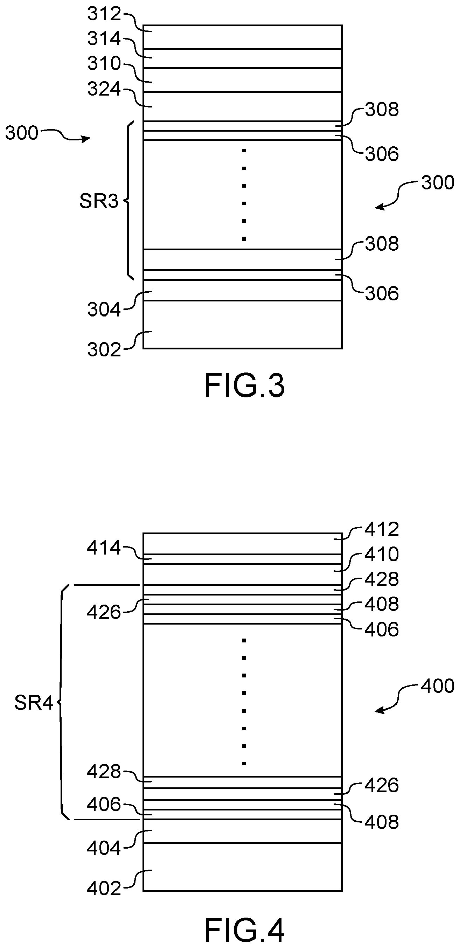

Sur la figure 3, on peut voir encore un autre exemple de structure semi-conductrice 300. La structure 300 comporte un substrat 302 par exemple en Si type (111), une couche tampon 304 par exemple en AIN, un super-réseau SR3 similaire au super-réseau SR1 de la structure 100, une couche de GaN 324 formée sur le super-réseau SR3, une couche intercalaire 310 formée sur la couche 324, la couche intercalaire étant similaire à la couche intercalaire 110, une couche 314 similaire à la couche 214.

Le GaN de la couche 324 est une couche de GaN dit 2D ou 2 dimensions c'est-à-dire qu'on ne génère pas de rugosité, il n'y a pas d'ilots « 3D » et la surface reste plate. La formation d'une telle couche est bien connue de l'homme du métier. La réalisation d'un empilement d'une couche de GaN 2D et d'une couche d'AIN présente l'avantage de faire apparaître à l'interface entre le GaN et l'AIN des fissures enterrées qui participent à la mise en compression de la couche de GaN 312. L'AIN pourrait être remplacé par du AlₓIn_{y}B_{z}Ga_{w}N avec x + y + z + w = 1 qui présente un paramètre de maille plus faible que les deux couches qui lui serait adjacentes. En variante encore, l'AIN pourrait être remplacé par du SiC néanmoins l'effet du SiC serait moindre qu'avec l'AIN ou AlₓIn_{y}B_{z}Ga_{w}N.

La couche de GaN 324 a une épaisseur par exemple comprise entre 50 nm et 2000 nm, de préférence égale à 500nm.

Le motif du super-réseau peut comporter plus de deux couches, il peut comporter n couches, n >_ 2, la composition de la couche n peut alors s'écrire AIₓₙGa₁₋ₓₙN, xn appartenant à l'intervalle [0; 1].

L'empilement 3214-310-314 pourrait être répété.

Sur la figure 4, on peut voir un autre exemple de structure semi-conductrice 400 dans laquelle n = 4. La structure 400 comporte un substrat 402, une couche tampon 404 et un super-réseau SR4. Le motif du super-réseau comporte quatre couches 406, 408, 426, 428. La couche 406 comporte le matériau Alₓ₁Ga_{y1}In_{w1}B_{z1}N avec x₁ + y₁ + w₁ +z₁ = 1. La couche 408 comporte le matériau Alₓ₂Ga_{y2}In_{w2}B_{z2}N avec x₂ + y₂ + w₂ +z₂ = 1. La couche 426 comporte le matériau Alₓ₃Ga_{y3}In_{w3}B_{z3}N avec x₃ + y₃ + w₃ +z₃ = 1. La couche 428 comporte le matériau Alₓ₄Ga_{y4}In_{w4}B_{z4}N avec x₄ + y₄ + w₄ +z₄ = 1. Les matériaux de deux couches successives dans le super-réseau sont différents. Chaque couche a une épaisseur inférieure à l'épaisseur critique. La structure 400 comporte également une couche intercalaire 410 formée sur le super-réseau SR4, la couche intercalaire 410 étant similaire à la couche intercalaire 110, une couche 414 similaire à la couche 214.

De préférence le motif a une épaisseur inférieure à 5 nm. Le super-réseau SR4 comporte un grand nombre de motifs, de préférence au moins 50.

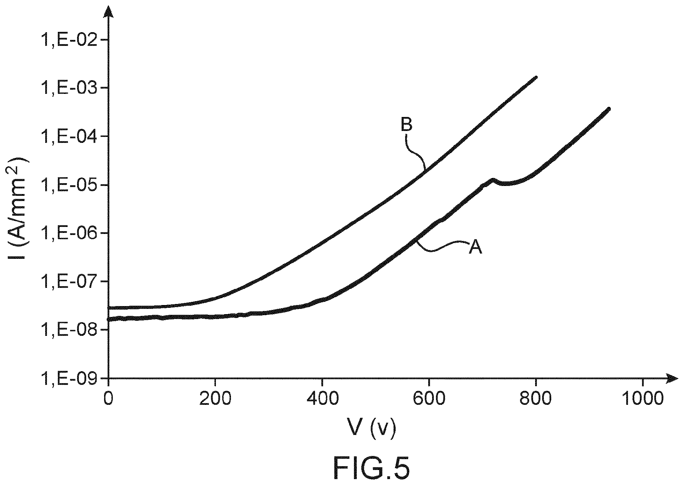

Sur la figure 5, on peut voir une représentation graphique de la variation du courant de fuite verticale I en A/mm²en fonction de la tension V en volts appliquée à travers l'empilement d'une structure selon l'invention (courbe A) et d'une structure comportant du GaN 3D à la place du super-réseau (courbe B). On constate que grâce à l'invention le courant de fuite verticale est réduit.

Quel que soit l'exemple de de réalisation ou la variante de réalisation, les différentes couches de la structure semi-conductrice sont réalisées par croissance, par exemple par épitaxie en phase vapeur aux organométalliques, notamment les couches du ou des super-réseaux, par dépôt chimique en phase vapeur ou MOCVD (Metalorganic Chemical Vapor Deposition en terminologie anglo-saxonne) ou par épitaxie par jets moléculaire ou MBE (Molecular Beam Epitaxy en terminologie anglo-saxonne).

A titre d'exemple, pour la croissance des couches par MOCVD, la température typique est de l'ordre de 1000°C, une pression de 100 mbar, sous hydrogène avec une pression partiel d'ammoniac de 30mbar

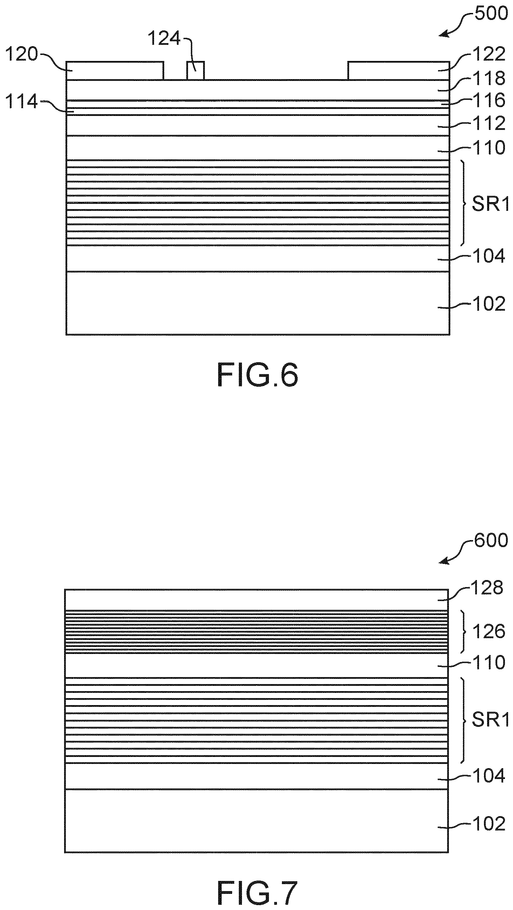

La couche de GaN 112 obtenue peut être utilisée en tant que couche active de dispositifs semi-conducteurs réalisés à partir du substrat formé par la structure 200. Par exemple, un transistor HEMT 300 peut être réalisé à partir de la couche 112 en GaN, comme représenté schématiquement sur la figure 6. Cette couche 112 est dopée, par exemple avec du carbone et avec une concentration par exemple égale à environ 10¹⁹ cm⁻³. Une couche supplémentaire 114 comprenant un semi-conducteur similaire à celui de la couche 112 et plus fine que la couche 112 (épaisseur par exemple égale à environ 100 nm, ou comprise entre environ 25 nm et 1 µm), et comportant également du carbone en tant que dopant avec une concentration par exemple égale à environ 5.10¹⁶ cm⁻³, est formée sur la couche 112. Cette couche supplémentaire 114 de GaN est destinée à former le canal du transistor HEMT 500. Une couche espaceur 116 comportant par exemple de l'AIN et d'épaisseur égale à environ 1 nm, est ensuite disposée sur la couche supplémentaire 114 de GaN. Enfin, une couche d'AlGaN 118, comportant par exemple un taux de gallium égal à environ 80 % et permettant d'assurer la formation d'un gaz d'électrons bidimensionnel dans le canal du transistor 300, est formée sur cette couche espaceur 116. Le transistor HEMT 300 est ensuite achevé par des étapes classiques telles que la formation des régions de source 120 et de drain 122, des contacts métalliques, de la grille 124, etc.

Il sera compris que les différents exemples de réalisation et les différentes variantes peuvent être combinés sans sortir du cadre de la présente invention.

La structure semi-conductrice selon l'invention est particulièrement adaptée à la réalisation de transistors haute puissance du fait de la haute tenue en tension, par exemple à la réalisation de HEMT. Mais elle peut également être mise en oeuvre dans la réalisation de structure de diodes électroluminescentes, la couche 112 de GaN est utilisée en tant que couche active d'une diode électroluminescente 600 comme représenté par exemple sur la figure 7. Dans ce cas, la couche 112 peut être dopée n par exemple avec du silicium. Une structure à puits quantiques 126 comportant des couches barrières de GaN et des couches émissives d'InGaN est ensuite formée sur la couche 112. Une couche 128 de GaN dopée p, par exemple avec du magnésium peut enfin être réalisée sur la structure à puits quantiques 126.

Un courant circulant entre les couches 112 et 128 provoque une émission dont la longueur d'onde correspondant au gap interdit de l'InGaN dans les puits.

## Revendications

1. Structure semi-conductrice comportant au moins :
- un substrat (102),
- une couche tampon (104),
- un super-réseau formé sur la couche tampon (104), ledit super-réseau comportant un motif comprenant n couches en des matériaux différents, n étant un entier au moins égal à 2, chaque couche (106, 108) comportant un matériau de type AlₓGa_{y}In_{w}B_{z}N avec x + y + w +z = 1, l'épaisseur de chaque couche (106, 108) étant inférieure à son épaisseur critique, le nombre de motifs étant au moins égal à 50,
- une couche intercalaire (110) dont le matériau présente un premier paramètre de maille,
- une couche de matériau de type III-N (112), dont le paramètre de maille est supérieur au premier paramètre de maille de sorte que la couche de matériau de type III-N (112) soit mise en compression par la couche intercalaire (110).

2. Structure semi-conductrice selon la revendication 1, dans laquelle l'épaisseur de chaque couche (106, 108) du super-réseau est inférieure ou égale à 5 nm, avantageusement égale à 1 nm.

3. Structure semi-conductrice selon la revendication 1 ou 2, dans laquelle l'épaisseur de chaque motif est inférieure ou égale à 5 nm.

4. Structure semi-conductrice selon l'un des revendications 1 à 3, comportant au moins une couche en matériau de type AlₓGa_{y}In_{w}B_{z}N avec x + y + w +z = 1 entre la couche intercalaire et la couche de matériau de type III-N présentant un deuxième paramètre de maille supérieur au premier paramètre de maille et inférieur au paramètre de maille du matériau de type III-N

5. Structure semi-conductrice selon l'une des revendications 1 à 4, dans laquelle la couche intercalaire a une épaisseur au moins égale à 10nm.

6. Structure semi-conductrice selon l'une des revendications 1 à 5, dans laquelle la couche intercalaire est une couche d'AIN ou un super-réseau.

7. Structure semi-conductrice selon l'une des revendications 1 à 7, dans laquelle le substrat comporte du silicium monocristallin et/ou le matériau de type III-N est du nitrure de Gallium.

8. Structure semi-conductrice selon l'une des revendications 1 à 7, comportant au moins une couche supplémentaire de matériau de type III-N interposée entre le super-réseau et la couche intercalaire et/ou au moins une couche supplémentaire de matériau de type III-N interposée entre la couche intercalaire et la couche de matériau III-N.

9. Structure semi-conductrice selon la revendication 8, dans laquelle la couche supplémentaire de matériau de type III-N a une épaisseur d'au moins 50 nm.

10. Structure semi-conductrice selon l'une des revendications 1 à 9, comportant plusieurs super-réseaux superposés.

11. Transistor comportant au moins une structure selon l'une des revendications 1 à 10.

12. Transistor selon la revendication 11, ledit transistor étant un transistor HEMT.

13. Procédé de réalisation d'une structure semi-conductrice comportant les étapes à partir d'un substrat :
a) formation d'une couche tampon,
b) formation d'un super-réseau comportant les sous-étapes :
b1) réalisation d'un motif comprenant n couches, n étant un entier au moins égal à 2, chaque couche comportant un matériau de type AlₓGa_{y}In_{w}B_{z}N avec x + y + w +z = 1, l'épaisseur de chaque couche étant inférieure à son épaisseur critique,
b2) répétition de l'étape b1) au moins 50 fois,
c) formation d'une couche intercalaire présentant un premier paramètre de maille,
d) formation d'une couche en matériau de type III-N dont le paramètre de maille est supérieur au première paramètre de maille.

14. Procédé de réalisation selon la revendication 13, dans lequel lors de l'étape b), du carbone est incorporé dans les couches du super-réseau.

15. Procédé de réalisation selon la revendication 13 ou 14, dans lequel les couches de la structure sont formées par croissance, avantageusement par épitaxie en phase vapeur aux organométalliques.
